# EUROPÄISCHE PATENTSCHRIFT

(11) **EP 2 979 298 B1**
(45) Veröffentlichungstag und Bekanntmachung des Hinweises auf die Patenterteilung: **22.03.2017**
(21) Anmeldenummer: 13714603.1
(22) Anmeldetag: 27.03.2013
(51) Int. Cl.: B25J 15/06, H01L 21/67, H01L 21/687

(54) **AUFNAHMEEINRICHTUNG, VORRICHTUNG UND VERFAHREN ZUR HANDHABUNG VON SUBSTRATSTAPELN**
RECEPTACLE DEVICE, DEVICE AND METHOD FOR HANDLING SUBSTRATE STACKS
SYSTÈME DE RÉCEPTION, DISPOSITIF ET PROCÉDÉ PERMETTANT DE MANIPULER DES EMPILEMENTS DE SUBSTRATS

(43) Veröffentlichungstag der Anmeldung: 03.02.2016
(73) Patentinhaber: EV Group E. Thallner GmbH, 4782 St. Florian am Inn (AT)
(72) Erfinder: THALLNER, Erich, A-4782 St. Florian (AT); LINDNER, Paul, A-4780 Schärding (AT)
(74) Vertreter: Schneider, Sascha
(86) Internationale Anmeldenummer: PCT/EP2013/056620
(87) Internationale Veröffentlichungsnummer: WO 2014/154272

(56) Entgegenhaltungen:
- EP-A1- 2 458 628
- US-A1- 2010 080 891

## Beschreibung

Die vorliegende Erfindung betrifft eine Aufnahmeeinrichtung zur Handhabung von Substratstapeln gemäß Anspruch 1, eine Vorrichtung zur Handhabung von Substratstapeln gemäß Anspruch 5, ein korrespondierendes Verfahren gemäß Anspruch 12, sowie einen Substratstapel nach Anspruch 13.

In der Halbleiterindustrie werden regelmäßig unterschiedliche Substrate, seien es Produktsubstrat- oder Trägersubstrat miteinander verbunden. Den Verbindungsvorgang nennt man Bonden. Man kann zwei unterschiedliche Bondarten unterscheiden, das Temporär- und das Permanentbonden. Beim Temporärbonden wird ein erstes Substrat, meist ein Produktsubstrat, mit einem zweiten Substrat, insbesondere einem Trägersubstrat, verbondet, um das Produktsubstrat durch das Trägersubstrat zu stabilisieren.

Nach weiteren Prozessen am Produktsubstrat kann dieses vom Trägersubstrat entfernt werden. In der Fachsprache nennt man den Entfernungsvorgang Debonden.

Beim Permanentbonden strebt man einen irreversible Verbindung zwischen zwei Substraten, meist zwei Produktsubstraten, an. Diese Bondingart dient vor allem dem Aufbau von Substratstapeln mit unterschiedlichen funktionalen Ebenen. In der Veröffentlichung: Dragoi, V. and Pabo, E., Wafer Bonding Process Selection, The Electrochemical Society, ECS Transactions 01/2010;33:509-517, findet man beispielsweise eine Übersicht über unterschiedliche Bondingverfahren.

Vor allem vor dem Permanentbonden müssen Produktsubstrate mit einer sehr hohen Präzision über Ausrichtungsmarken, die sich an deren Oberflächen befinden, zueinander justiert werden. Die Ausrichtung und das Bonden der Substrate erfolgt dabei bis heute hauptsächlich in unterschiedlichen Modulen, einem Ausrichtungs- und einem Bondmodul. Letzteres wird vereinfacht als Bonder bezeichnet. Ein kritischer Aspekt der Trennung von Ausrichtungs- und Bondmodul besteht im Transport der zueinander ausgerichteten Substrate vom Ausrichtungs- zum Bondmodul. Auf diesem Weg, sei er auch noch so kurz, kann es zu einer Verschiebung der beiden Substrate zueinander kommen. Eine Fixierung der zueinander ausgerichteten Substrate ist daher notwendig.

Im Stand der Technik erfolgt die Fixierung zweier Substrat beispielsweise mit mechanischen Klemmen. Die mechanischen Klemmen sind meistens mit einem Substrathalter (engl.: chuck bzw. fixture) verbunden. Eines der beiden Substrate liegt direkt am Substrathalter. Nachdem das zweite Substrat relativ zum ersten Substrat ausgerichtet wurde, werden beiden Substrate kontaktiert. Sehr oft werden Abstandshalter, die vom Rand zwischen die beiden Substrate eingeführt werden verwendet, um den vollständigen Kontakt der beiden Substrate miteinander bis zum eigentlichen Bondvorgang zu verhindern. Unabhängig von der Verwendung der Abstandshalter können mechanische Klemmen beide Substrate am Substrathalter fixieren. Verwendet man die Substrathalter zur Aufnahme und Fixierung der beiden Substrate, müssen Substrathalter und Substrate entweder manuell oder vollautomatisch durch einen Roboterarm vom Ausrichtungsmodul zum Bondmodul transferiert werden.

Aus den Druckschriften EP 2 458 628 A1 und US 201010080891 A1 sind Substrathalter gemäß dem Stand der Technik bekannt.

Aufgabe der vorliegenden Erfindung ist es, eine Aufnahmeeinrichtung und eine Vorrichtung sowie ein entsprechendes Verfahren anzugeben, mit welchen die Handhabung von Substratstapein verbessert und/oder vereinfacht wird.

Diese Aufgabe wird mit den Merkmalen der Ansprüche 1, 5, 12 und 13 gelöst.

Die Erfindung betrifft ein insbesondere ein Verfahren und eine Vorrichtung zum Ausrichten, Klemmen und Bonden zweier (Halbleiter-)Substrate beziehungsweise eines aus den beiden (oder mehreren) Substraten gebildeten Substratstapel. Die erfindungsgemäße Methode wird mit Vorzug in einer Ultrahochvakuumumgebung verwendet.

Der Erfindung liegt der Gedanke zugrunde, zwei (oder mehrere) ausgerichtete Substrate durch magnetische Fixiermittel, insbesondere unter Weglassung einer Aufnahmeeinrichtung (chuck bzw. fixture) auf wenigstens einer der beiden von Kontaktseiten der Substrate abgewandten Halteseiten des Substratstapels, aneinander festzulegen, so dass die Substrate als in einer Festlegungsposition zueinander ausgerichteter Substratstapel gehandhabt werden können.

Insbesondere handelt die Erfindung von einem Verfahren, zwei oder mehrere Substrate, die einen Substratstapel bilden, über mindestens zwei, sich auf den jeweils gegenüberliegenden Seiten des Substratstapels befindenden, Magnete zu fixieren. Die durch die Magnete erzeugte Haltekraft ist dabei höher als 0.01N, mit Vorzug größer als 0.1N, mit größerem Vorzug größer als 1N, mit noch größerem Vorzug größer als 10N, mit größtem Vorzug größer als 100N. Die hier angegebenen Kraftwerte werden am einfachsten dadurch bestimmt, dass mindestens einer der beiden Magnete an einer Federwaage befestigt wird und in die Nähe des zweiten Magneten gebracht wird, sodass die zwischen den beiden Magneten entstehende Kraftwirkung zu einer Dehnung der Federwaage und damit zu einer einfachen Bestimmung der, durch die magnetische Anziehungskraft beider Magnete hervorgerufenen, Kraft führt. Bei vertikaler Lage und unterschiedlichen Massen der beiden Magnete können die berechneten Kraftwerte gegen die Schwerkraft korrigiert werden. Die Messung der Magnetkraft kann aber auch durch jede andere bekannte und erprobte Methode bestimmt werden.

Im Allgemeinen kann man bei Stabmagneten ein dem Coulomb'schen Gesetz äquivalentes magnetisches Kraftgesetz erkennen. Die magnetische Kraft ist dabei direkt proportional zum Produkt der Polstärken der beiden Magnete, aber umgekehrt proportional zum Quadrat des Abstandes. Die Magnetkraft nimmt als mit zunehmendem Abstand r mit 1/r² ab. Dieses Gesetz kennt man auch unter dem Namen "Magnetostatisches Kraftgesetz".

Da eine minimale Haltekraft nötig ist, um eine erfindungsgemäße Fixierung der beiden Substrate zueinander zu gewährleisten und die Dicke eines jeden Substrats meistens sehr gut bestimmt werden kann, ergibt sich durch die Anwendung des "Magnetostatischen Kraftgesetzes" eine Möglichkeit, die minimale magnetische Kraft zu bestimmen die notwendig ist, um die beiden Substrate miteinander zu fixieren. Dadurch erhält man die Möglichkeit, ein magnetisches Material gezielt auszuwählen, welches in der Lage ist, für eine gegebene Substratstapeldicke die entsprechende minimale Kraft aufzubringen.

Bei den erfindungsgemäßen Substraten handelt es sich vorzugsweise um Substrate, insbesondere Halbleitersubstrate, vorzugsweise Wafer. Diese weisen insbesondere eine Dicke unter 1500 µm, noch bevorzugter unter 1000 µm, auf.

Für die Handhabung (insbesondere den Transport von einem Ausrichtungsmodul zu einem Bondmodul oder anderen Bearbeitungsmodulen) kann somit auf den Mittransport einer Aufnahmeeinrichtung (Substrathalter) auf einer der beiden oder auf beiden Halteseiten des Substratstapels verzichtet werden. Die Substrathalter sind meistens sehr teure, insbesondere für ein Modul optimierte, schwere Werkzeuge. Der Transport der Substrathalter zwischen den Modulen ist daher mit Energie und Kosten verbunden, die mit der Erfindung eingespart werden kann. Vor allem bei der Anwendung in Ausrichtungsmodulen, in welchen mit Vorzug andere Substrathalter als in Bondmodulen verwendet werden, ist die vorliegende Erfindung von großem technischem Vorteil, da der Substratstapel einzig mit den Fixiermitteln bewegt werden kann beziehungsweise transportierbar ist, ohne dass die Ausrichtung der Substrate des Substratstapels beeinträchtigt wird.

Auf die Verwendung eines Substrathalters zum Transport der ausgerichteten Substratstapel zwischen den Modulen kann also gänzlich verzichtet werden.
Dadurch ergeben sich nicht nur die genannten Energie- und Kosteneinsparungen, sondern auch eine Freistellung der benötigten Substrathalter für die eigentlich gedachten Zwecke, für die sie konstruiert wurden. Die Zweckentfremdung der Substrathalter für den Transport wird durch die erfindungsgemäßen Ausführungsformen somit umgangen.

Die erfindungsgemäße Aufnahmeeinrichtung wird weitergebildet, indem die Ausnehmung(en) als mindestens ein am Umfang angeordneter Absatz mit einem Auflageabschnitt zur Auflage der Fixiermittel und einem zum Zentrum der Auflagefläche gerichteten Auflageabschnitt zur Anlage der Fixiermittel ausgebildet sind. Erfindungsgemäß werden die Fixiermittel, insbesondere in Form von Magnetkörpern, zumindest überwiegend, vorzugsweise vollständig, durch ihr eigenes Gewicht in den Ausnehmungen gehalten bis die Substrate in einer Festlegungsposition durch die Fixiermittel festgelegt sind. Dabei ist es von Vorteil, wenn die Ausnehmungen am Umfang gleichmäßig verteilt, insbesondere durchgehend umlaufend, und/oder jeweils gegenüberliegend angeordnet sind.

Gemäß einer weiteren vorteilhaften Ausführungsform der Aufnahmeeinrichtung ist der Auflageabschnitt gegenüber der Aufnahmefläche um einen Winkel a kleiner 60°, insbesondere a kleiner 45°, vorzugsweise a kleiner 30°, noch bevorzugter a kleiner 15°, geneigt. Hierdurch wird ein selbsttätiges Bewegungen der Fixiermittel, insbesondere der Magnetkörper, vorzugsweise kugelförmiger Magnetkörper, ermöglicht, solange die Fixiermittel noch nicht in der Festlegungsposition sind oder die magnetische Wirkung der Fixiermittel aufgehoben wird.

Gemäß einer vorteilhaften Ausführungsform der erfindungsgemäßen Vorrichtung weisen die Fixiermittel mindestens zwei Magnetelementpaare auf. Durch die Anordnung der Magnetkörper der Magnetelementpaare an Halteseiten des Substratstapels werden die Substrate in der ausgerichteten Festlegungsposition zumindest überwiegend, vorzugsweise vollständig, durch die Magnetkraft der Magnetelementpaare fixiert.

Indem jedes Magnetelementpaar aus einem ersten magnetisch wirksamen Magnetkörper und einem von dem ersten Magnetkörper magnetisch angezogenen zweiten, insbesondere magnetisch wirksamen, Magnetkörper gebildet ist, können die Substrate in der ausgerichteten Festlegungsposition mit geringem Aufwand festgelegt werden. Mit Vorteil sind die ersten Magnetkörper von den zweiten Magnetkörpern räumlich getrennt.

In Weiterbildung der Vorrichtung ist es vorgesehen, die ersten und/oder die zweiten Magnetkörper kugelförmig auszubilden. Durch kugelförmige Ausgestaltung wird die Auflagefläche auf der Halteseite der Substrate minimiert und die kugelförmigen Magnetkörper können nach oder während des Bondvorganges auf einfache Weise von der jeweiligen Halteseite mechanisch abgestreift werden. Durch die gegenseitig erzwungene Polausrichtung zweier Magnetkugeln auf jeweils einer der Oberflächen der zueinander zu fixierenden Substrate sind die Magnetkörper in ihrer gegenüberliegenden Position festgelegt.

Die Magnetkörper können durch einen der folgenden Methode entfernt werden
- Aktives, mechanisches Abstreifen oder Abrollen mit einer mechanischen Vorrichtung,
- Passives mechanisches Abfallen durch Verlust der magnetischen Kraft mindestens eines der Magnetkörper, hervorgerufen durch Entmagnetisierung mittels Temperatur und/oder magnetischen Wechselfeldern,
- Mechanisches Ergreifen der Magnetkörper mittels eines Greifers und/oder
- Magnetisches Anziehen der Magnetkörper mit einem oder mehreren Magneten

Gemäß einer weiteren vorteilhaften Ausführungsform der Erfindung ist es vorgesehen, dass die Vorrichtung eine Ausrichtungseinrichtung zur Ausrichtung des ersten Substrats relativ zu dem zweiten Substrat sowie eine Kontaktierungseinrichtung zur Kontaktierung der Substrate aufweist. Mit Vorteil ist es weiterhin vorgesehen, dass die Vorrichtung eine Platzierungseinrichtung zur Platzierung der Fixiermittel, insbesondere der Magnetkörper, auf voneinander abgewandten Seiten des Substratstapels aufweist.

Die zur Aufnahmeeinrichtung beschriebenen Merkmale sollen auch als Merkmale des nachfolgend beschriebenen Verfahrens als offenbart gelten und umgekehrt.

Als eigenständige Erfindung wird auch ein Verfahren zur Handhabung eines aus einem ersten Substrat und einem gegenüber dem ersten Substrat ausgerichteten zweiten Substrat bestehenden, zu bondenden Substratstapels offenbart, wobei das erste Substrat zur Handhabung des Substratstapels relativ zu dem zweiten Substrat durch magnetisch wirkende Fixiermittel in einer ausgerichteten Festlegungsposition festgelegt wird.

Dabei ist es gemäß einer vorteilhaften Ausführungsform des Verfahrens vorgesehen, dass die Fixiermittel auch voneinander abgewandten Halteseiten des Substratstapels platziert werden.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen jeweils in schematischer Ansicht:
- Fig. 1: eine erste Ausführungsform eines erfindungsgemäß mit Fixiermitteln festgelegten Substratstapels,
- Fig. 2: eine zweite Ausführungsform eines erfindungsgemäß mit Fixiermitteln festgelegten Substratstapels,
- Fig. 3: eine dritte Ausführungsform eines erfindungsgemäß mit Fixiermitteln festgelegten Substratstapels,
- Fig. 4a: ein erster Prozessschritt einer Ausführungsform des erfindungsgemäßen Verfahrens,
- Fig. 4b: ein zweiter Prozessschritt der Ausführungsform gemäß Fig. 4a,
- Fig. 4c: ein dritter Prozessschritt der Ausführungsform gemäß Fig. 4a,
- Fig. 4d: ein vierter Prozessschritt der Ausführungsform gemäß Fig. 4a,
- Fig. 4e: ein fünfter Prozessschritt der Ausführungsform gemäß Fig. 4a,
- Fig. 4f: ein sechster Prozessschritt der Ausführungsform gemäß Fig. 4a,
- Fig. 4g: ein siebter Prozessschritt der Ausführungsform gemäß Fig. 4a,
- Fig. 4h: ein achter Prozessschritt der Ausführungsform gemäß Fig. 4a,
- Fig. 4i: ein neunter Prozessschritt der Ausführungsform gemäß Fig. 4a,
- Fig. 4j: ein zehnter Prozessschritt der Ausführungsform gemäß Fig. 4a,
- Fig. 4k: ein elfter Prozessschritt der Ausführungsform gemäß Fig. 4a,
- Fig. 5a: eine erste Ausführungsform einer erfindungsgemäßen Vorrichtung und
- Fig. 5b: eine zweite Ausführungsform einer erfindungsgemäßen Vorrichtung,
- Fig. 6: ein Magnetkraft-Abstandsdiagramm mit zwei Kurven für zwei unterschiedliche magnetische Materialien,
- Fig. 7a: eine erfindungsgemäße erste Ausführungsform zur Entfernung der Magnetkörper
- Fig. 7b: eine erfindungsgemäße zweite Ausführungsform zur Entfernung der Magnetkörper
- Fig. 7c: eine erfindungsgemäße dritte Ausführungsform zur Entfernung der Magnetkörper

In den Figuren sind Vorteile und Merkmale der Erfindung mit diese jeweils identifizierenden Bezugszeichen gemäß Ausführungsformen der Erfindung gekennzeichnet, wobei Bauteile beziehungsweise Merkmale mit gleicher oder gleichwirkender Funktion mit identischen Bezugszeichen gekennzeichnet sind.

In den Figuren sind die erfindungsgemäßen Merkmale nicht maßstabsgetreu dargestellt, um die Funktion der einzelnen Merkmale überhaupt darstellen zu können. Auch die Verhältnisse der einzelnen Bauteile sind teilweise unverhältnismäßig.

Für die beschriebenen Ausführungsformen werden erfindungsgemäße Fixiermittel in Form von Magnetkörpern 5, 5', 5" aus unterschiedlichen Materialien und mit unterschiedlichen Geometrien verwendet. Die Magnete sind insbesondere ferromagnetisch. Sie bestehen vorzugsweise aus einem der folgenden Elemente oder aus einer der vorliegenden Legierungen.
- insbesondere für Raum- und Hochtemperaturanwendungen: Eisen, Nickel, Kobalt,
- insbesondere für Tieftemperaturanwendungen: Gadolinium, Terbium, Dysprosium, Holmium und Erbium,
- Legierungen: A1NiCo, SmCo, Nd2Fe14B, EuO, CrO2, Ni80Fe20, NiFeCo-Legierungen, Heuslerlegierungen.

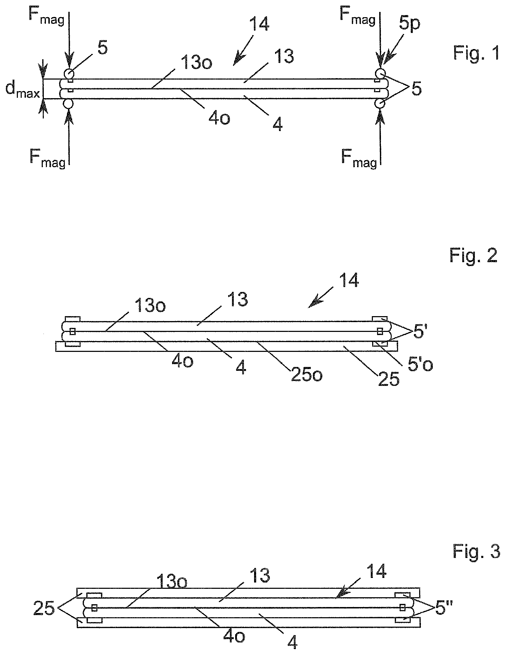

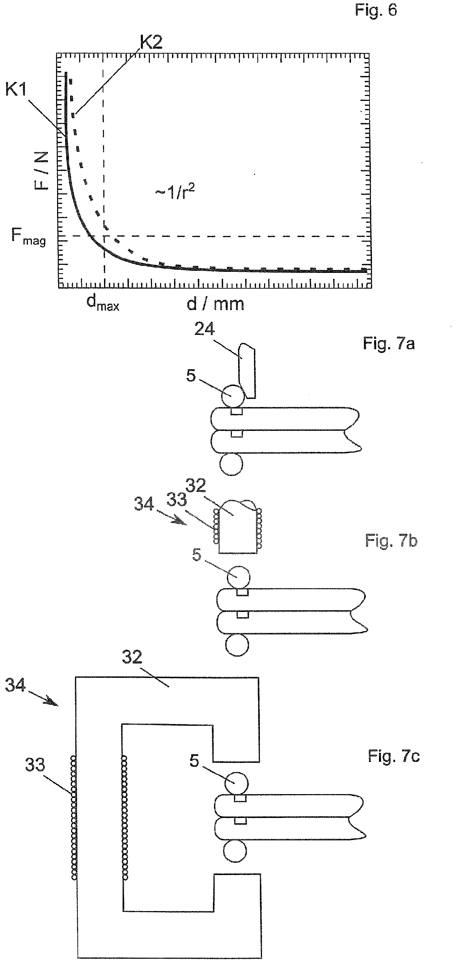

Die Auswahl der Materialien für die Magnetkörper kann wie folgt erfolgen. Für eine gegebene maximale Substratstapeldicke dₘₐₓ (Figur 1 und Figur 6) benötigt man eine minimale Haltekraft, also eine minimale magnetische Kraft F_{mag}. Diese minimale Haltekraft F_{mag} wird durch die Magnetkörper 5 aufgebracht. Um zu gewährleisten, dass mindestens diese minimale magnetische Kraft F_{mag} anliegt, muss gemäß Figur 6 das Material K2 ausgewählt werden, dessen Magnetkraft-Abstandskurve punktiert dargestellt wurde.

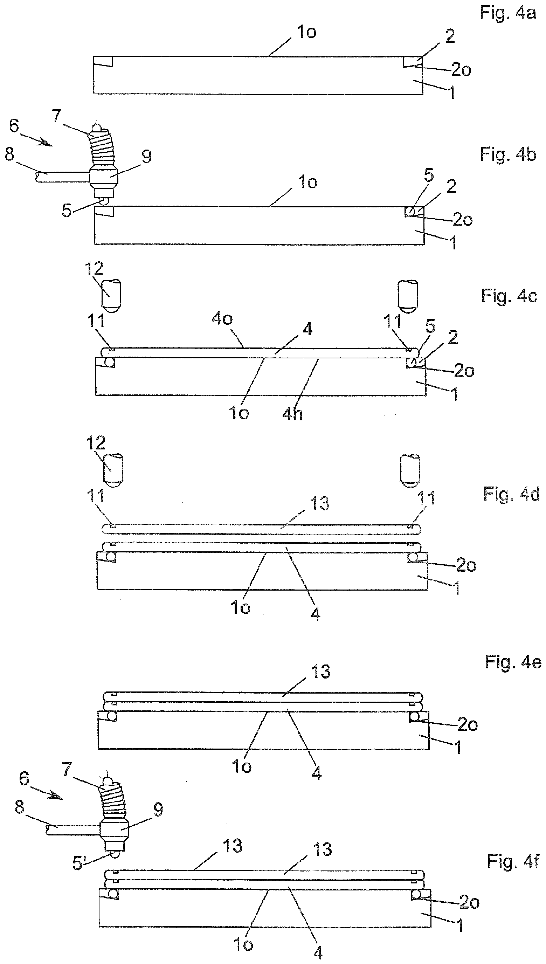

In den Figuren 1 bis 3 sind aus einem ersten Substrat 4 und einem zweiten Substrat 13 gebildete Substratstapel 14 dargestellt, die an einer ersten Kontaktfläche 4o des ersten Substrats 4 und einer zweiten Kontaktfläche 13o des zweiten Substrats 13 zueinander genau ausgerichtet sind. Die Abweichung von der exakten Ausrichtung der beiden Substrate 4 und 13 innerhalb der horizontalen Ebene, welche parallel zu den beiden Oberflächen 4o und 13o ist, ist dabei kleiner als 1mm, mit Vorzug kleiner als 10µm, mit größerem Vorzug kleiner als 1µm, mit noch größerem Vorzug kleiner als 100nm, mit größtem Vorzug kleiner als 10nm, mit allergrößtem Vorzug kleiner als 1nm. Zur Ausrichtung sind insbesondere Ausrichtungsmarkierungen 11 (siehe Fig. 4d) vorgesehen. Der Substratstapel 14 wird durch Fixiermittel in Form von Magnetkörpern 5 in einer Festlegungsposition fixiert.

In einer ersten Ausführungsform gemäß Figur 1 sind die Magnetkörper 5 kugelförmig. Die Magnetkörper 5 sind jeweils als Magnetelementpaare 5p an zwei jeweils zur ersten und zweiten Kontaktfläche 4o, 13o abgewandten Halteseiten 4h, 13h angeordnet. Die Magnetkörper 5 jedes Magnetelementpaares 5p sind durch die gegenseitige magnetische Anziehung selbstfixierend. Die Magnetkörper 5 üben hierdurch eine in Richtung der jeweiligen Halteseiten 4h, 13h, an welchen Sie angeordnet sind, eine Normalkraft aus, wodurch die Substrate 4, 13 aneinander festgelegt werden.

Kugelförmige Magnetkörper 5 haben den Vorteil, die sie berührenden Substrate 4, 13 nur punktförmig zu belasten. Auf Grund der Tatsache, dass die auftretenden Kräfte zwar groß genug sind, um die Substrate 4 und 13 zusammen zu halten, aber auf keinen Fall ausreichen um eines der beiden Substrate zu zerstören, ergibt sich dadurch ein lokal begrenzter, relativ hoher Druck mit nur wenig Magnetkörpern 5. Des Weiteren wird die Kontamination der Halteseiten 4h, 13h beziehungsweise der gesamten Oberfläche der Substrate 4, 13 bei punktförmiger Belastung minimiert, was für hochreine Prozesse vorteilhaft ist. Eine Entfernung der kugelförmigen Magnetkörper 5' erfolgt vorzugsweise durch mechanisches Abstreifen oder einer der anderen offenbarten Methoden entlang der jeweiligen Halteflächen 4h, 13h.

In einer weiteren Ausführungsform gemäß Figur 2 sind die Magnetkörper 5' zylinderförmig. Zylinderförmige Magnetkörper 5' bieten den Vorteil, dass die auftretende magnetische Kraft sich zumindest nicht völlig punktförmig anliegt, sondern über eine Auflagefläche 5o' der Magnete 5' verteilt. Der Nachteil besteht in der schwierigeren Entfernung der zylindrischen Magnete nach einem Prozessschritt, da die zylindrischen Magnetkörper 5' nicht so einfach wie die kugelförmigen Magnetkörper 5 abgerollt werden können, es sei denn man fixiert sie so, dass deren Zylinderachse parallel zu den Substratoberflächen 4, und 13o liegt.

Insbesondere können die Magnetkörper 5' in eine Trägerplatte 25 integriert beziehungsweise eingearbeitet ausgebildet sind, die neben der Aufnahme der Magnetkörper 5' zur Stützung des Substratstapels 14 an einer Stützfläche 25o der Trägerplatte 25 dient.

In einer weiteren Ausführungsform gemäß Figur 3 wird ein ringförmiger Magnetkörper 5" verwendet, dessen äußere Form, im Spezialfall runder Substrate 4, 13 deren Durchmesser, dem jeweiligen Substrat 4, 13 entspricht. Die Dicke des offenbarten Magnetkörpers 5" quer zur Halteseite 4h, 13h beträgt wenige mm. Mit Vorzug ist die Dicke des Magnetkörpers 5" größer als 0,1mm, mit Vorzug größer als 0,5mm, mit größerem Vorzug größer als 1,0mm, mit noch größerem Vorzug größer als 2mm, mit größtem Vorzug größer als 3mm, mit allergrößtem Vorzug größer als 5mm, jedoch insbesondere kleiner als 10mm. Ringförmige Magnete 5" können erfindungsgemäß ebenfalls in die beschriebenen Trägerplatten 25 mit entsprechenden Ausformungen eingebaut werden.

In einer weiteren vorteilhaften Ausführungsform wird anstelle der vorgenannten Varianten mindestens ein torusförmiger Magnetkörper verwendet, dessen äußerer Form insbesondere, im Spezialfall von runden Substraten 4, 13 deren Durchmesser, dem Substrat ähnelt. Es ist eine Vielzahl kleiner torusförmiger Magnetkörper analog der oben beschriebenen zylindrischen Ausführungsform oder ein einziger torusförmiger Magnetkörper analog der oben beschriebenen ringförmigen Ausführungsform erfindungsgemäß denkbar.

Erfindungsgemäß wird das erste Substrat 4 mit dem zweiten Substrat 13 über mindestens zwei Magnetelementpaare 5p von Magnetkörpern 5, 5', 5" miteinander verbunden.

In jeweils alternativen Ausführungsformen befindet sich bei jedem Magnetelementpaar 5p nur ein magnetischer Magnetkörper 5, 5', 5" auf einer der Halteseiten 4h, 13h eines Substratstapels 14, während sich auf der anderen Seite ein, insbesondere von der Form korrespondierender, Magnetkörper 5, 5', 5" aus "magnetisierbares Material" befindet. Ein "magnetisierbares Material" ist durch die im Vergleich zum magnetischen Magnetkörper 5, 5', 5" wesentlich geringere, Magnetisierung ausgezeichnet. Durch die Nähe zum Magneten 5, 5', 5" erfolgt eine zumindest teilweise Magnetisierung, sodass von einem Magneten im Sinne der Erfindung gesprochen werden kann. Bei den "magnetisierbaren Materialien" handelt es sich mit Vorzug um eines der folgenden Elemente oder Legierungen:
- (ferritischer) Stahl, Eisen
- Mu-Metall
- Ferromagnet amorphe Metalle
- Ferromagnetische nanokristalline Metalle

Erfindungsgemäß liegt die im Auflagepunkt eines kugelförmigen Magnetkörpers 5 wirkende Klemmkraft bei mehr als 0,01N, mit Vorzug mehr als 0.1N, mit größerem Vorzug mehr als 1N, mit größtem Vorzug mehr als 10N, mit allergrößtem Vorzug mehr als 100N, jedoch weniger als 1000N. Die korrespondierenden Drücke berechnen sich anhand bekannter Formeln abhängig von der jeweils verwendeten Geometrie der Magnete. Die Klemmkraft bewirkt zusammen mit dem Haftreibungskoeffizienten der Oberflächen der beiden sich miteinander an den Kontaktflächen 4o, 13o in Kontakt befindenden Substrate 4, 13 eine entsprechend zu überwindende Haftreibung.

Im Folgenden wird eine Ausführungsform eines erfindungsgemäßen Verfahrens beschrieben, bei welchem die erfindungsgemäße Fixiermethode mit den Magneten 5, 5', 5" verwendet wird, um zwei Substrate 4 und 13, die nach einem Ausrichtungsprozess einen Substratstapel 14 bilden, zu fixieren beziehungsweise festzulegen.

In einem ersten Prozessschritt gemäß Fig. 4a wird ein erster Substrathalter 1 (Aufnahmeeinrichtung) in einem Ausrichtungsmodul 3 einer Prozessanlage (Cluster 17) vorbereitet. Der Substrathalter 1 besitzt eine Aufnahmefläche 1o zur Aufnahme des ersten Substrats 4. Weiterhin weist der Substrathalter 1 mindestens eine, mit Vorzug mindestens zwei, mit größerem Vorzug mindestens oder mehr als drei, mit noch größerem Vorzug mehr als sechs, mit noch größerem Vorzug mehr als 9, mit allergrößtem Vorzug mehr als 12 Ausnehmungen 2 auf. Die Ausnehmungen 2 sind mit Vorzug an die Form der erfindungsgemäßen Magnetkörper 5 angepasst. Handelt es sich bei den Magnetkörpern 5 um kugelförmige, verläuft ein Auflageabschnitt 2o mit Vorzug um einen Winkel a schräg nach innen, um die kugelförmigen Magnetkörper 5 am Wegrollen/Herausfallen zu hindern, bis die Festlegungsposition hergestellt ist und die Magnetkörper 5 sich gegenseitig fixieren.

Handelt es sich bei den Magnetkörpern 5' um zylinderförmige Magnetkörper 5', verläuft der Auflageabschnitt 2o mit Vorzug parallel zur Aufnahmefläche 1o, damit die zylinderförmigen Magnetkörper 5'stabil aufsetzen können.

In einem zweiten Prozessschritt gemäß Fig. 4b werden die erfindungsgemäßen Magnetkörper 5 in die Ausnehmungen 2 platziert. Die Platzierung kann manuell oder bevorzugt durch eine semi-, noch bevorzugter vollautomatische Platziereinrichtung 6 erfolgen. Denkbar wäre beispielsweise die Auffüllung der Ausnehmungen 2 mit kugelförmigen Magnetkörpern 5 mittels der semi- bzw. vollautomatischen Platziereinrichtung 6, bestehend aus einem Schlauch 7 zur kontinuierlichen Zufuhr von kugelförmigen Magnetkörpern 5, einer Halterung 8, sowie eines Ventils 9, welches an die Ausnehmungen 2 heranführbar ist. Am Ende des Schlauchs 7 befindet sich ein entsprechend vollautomatisch geregeltes Ventil 9, das die Magnetkörper 5 einzeln ausstoßen kann und kontinuierlich über den Schlauch 7 mit weiteren Kugelmagneten 5 versorgt wird. Die Steuerung erfolgt durch eine, insbesondere softwaregestützte Steuerungsrichtung, die auch für die Steuerung der übrigen Einrichtungen der Prozessanlage verantwortlich ist.

In einem dritten Prozessschritt gemäß Fig. 4c wird das erste Substrat 4 mit seiner Halteseite 4h auf der Aufnahmefläche 1o des ersten Substrathalters 1 abgelegt. Das erste Substrat 4 kann jede beliebige Form besitzen und insbesondere an seiner Kontaktfläche 4k beliebig strukturiert sein. Mit Vorzug besitzt das erste Substrat 4 Ausrichtungsmarkierungen 11. Die Positionen der Ausrichtungsmarkierungen 11 können von entsprechenden Optiken 12 im Ausrichtungsmodul 3 detektiert werden. Mit den detektierten Daten ist eine Steuerung über die Steuerungseinrichtung möglich.

In einem vierten Prozessschritt gemäß Fig. 4d wird das zweites Substrat 13 zu dem ersten Substrat 4 ausgerichtet. Die Ausrichtungsmarkierungen 11 dienen dabei als Referenzpunkte. In Fig. 4d erkennt der Fachmann ein sogenanntes "backside-alignment". In dieser speziellen Ausrichtungsart befinden sich die Ausrichtungsmarken 11 immer auf derselben Seite der jeweiligen Substrate. Grundsätzlich kann aber jede Ausrichtungsart verwendet werden. Ein zweiter Substrathalter, der das Substrat 13 hält, ist der Übersichtlichkeit halber nicht eingezeichnet, entspricht aber dem ersten Substrathalter 1. Alle Substrathalter können insbesondere transparent für Infrarotlicht und/oder sichtbares Licht sein.

In einer alternativen Ausführungsform können entsprechende Löcher, Bohrungen oder Durchgänge den Optiken 12 die Sicht auf die Ausrichtungsmarken 11 erlauben.

In einem fünften Prozessschritt gemäß Fig. 4e werden die beiden Substrate 4 und 13 miteinander in Kontakt gebracht.

In einem sechsten Prozessschritt gemäß Fig. 4f werden kleine Magnetkörper 5, mit Vorzug dieselben Magnetkörper wie im zweiten Prozessschritt, auf die Halteseite 13h des zweiten Substrats 13 aufgebracht. Mit Vorzug wird dabei wieder dieselbe Platziereinrichtung 6 wie im zweiten Prozessschritt verwendet.

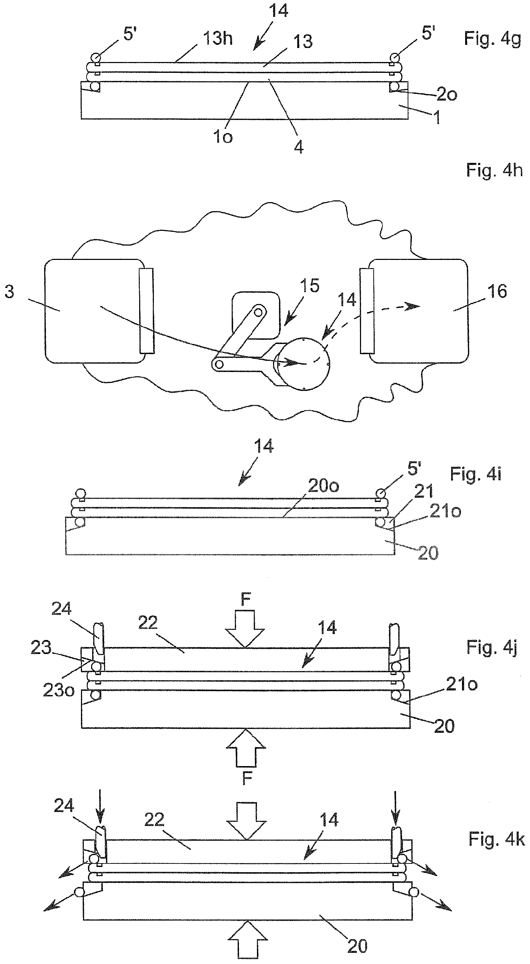

In einem siebten Prozessschritt gemäß Fig. 4g liegt ein erfindungsgemäß mittels mehrerer Magnetkörper 5 fixierter Substratstapel 14, bestehend aus mindestens zwei Substraten 4, 13 vor. Die erfindungsgemäße Ausführungsform erlaubt auch die Fixierung von mehr als zwei Substraten, indem die Prozessschritte gemäß Figuren 4d und 4e gegebenenfalls mehrfach wiederholt werden.

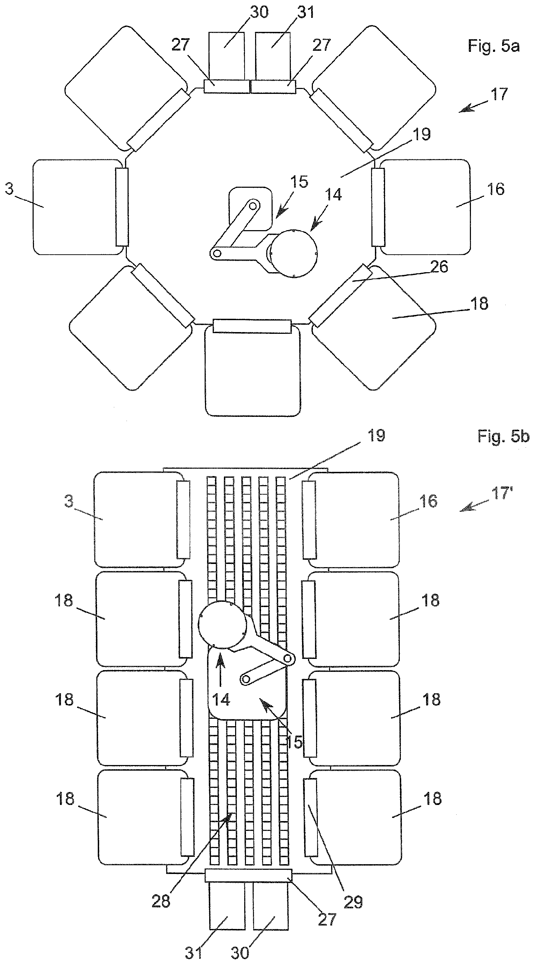

In einem achten Prozessschritt gemäß Fig. 4h wird der erfindungsgemäße Substratstapel 14 durch ein Robotertransportsystem 15 von dem Ausrichtungsmodul 3 zu einem Bondmodul 16 transportiert. Das Ausrichtungsmodul 3 und das Bondmodul 16 sind mit Vorzug Teil eines Clusters 17, insbesondere einem Hochvakuumcluster (siehe Fig. 5a oder Fig. 5b). In dem Cluster 17 können sich weitere andere Module 18 für die Prozessierung des Substratstapels 14 befinden. Bei den Modulen 18 kann es sich um Analysemodule, Heizmodul, Kühlmodule, Belackungsmodule, im speziellen Schleuder- und Sprühbelackungsmodule, Entwicklermodule, Ätzmodule, Reinigungsmodule etc. handeln. Der Cluster 17 ist mit Vorzug ein Hochvakuumcluster. Die Module 3, 16, 18 sind in einer Zentralkammer 19 eingeschlossen, die evakuierbar ist. Des Weiteren sind alle Module 3,16,18 mit Vorzug hermetisch zur Zentralkammer 19 abschließbar und können unabhängig von der Zentralkammer 19 evakuiert werden. Die Zentralkammer 19 ist über eine Schleuse 18 mit der Umgebung verbunden.

In einem neunten Prozessschritt gemäß Figur 4i wird der erfindungsgemäße Substratstapel 14 auf eine Aufnahmefläche 20o eines Bondchucks 20 (Aufnahmeeinrichtung) mit Bondchuckausnehmungen 21 abgelegt. Auflageabschnitte 21o der Bondchuckausnehmungen 21 sind mit Vorzug so gefertigt, dass bei einem Verlust der magnetischen Wirkung der Magnetkörper 5 der Magnetpaare 5p eine automatische Entfernung der Magnete 5 durch die Schwerkraft erfolgt. Insbesondere weisen die Auflageabschnitte 21o eine Neigung gegenüber der Auflagefläche 20o des Bondchucks 20 auf, insbesondere um einen Winkel a'.

In einem zehnten Prozessschritt gemäß Figur 4j wird der Bondvorgang durchgeführt, indem eine Druckplatte 22 mit Druckplattenausnehmungen 23 an der Halteseite 13h des zweiten Substrats 13 auf den Substratstapel 14 drückt und den Bondvorgang durchführt. Der Bondvorgang wird meist bei erhöhten Temperaturen durchgeführt. Dabei wird der Substratstapel 14 über den Bondchuck 20 und/oder die Druckplatte 22 geheizt. Mit Vorzug befinden sich im Bondchuck und/oder der Druckplatte entsprechende (nicht eingezeichnete) Heizelemente. Die Druckplattenausnehmungen 23 weisen, insbesondere zur Auflagefläche 20o geneigt verlaufende, Oberflächen 23o auf.

In einer Erweiterung der erfindungsgemäßen Ausführungsform werden die Magnetkörper 5 über die Curie-Temperatur erwärmt, sodass sie ihre Magnetisierung verlieren und mit Vorzug automatisch vom Substratstapel 14 abfallen (Fig. 4k). Die Magnetkörper 5 in den Bondchuckausnehmungen 21 fallen mit Vorzug durch die entsprechende konstruktionstechnische Ausführungsform der Bondchuckausnehmungen alleine durch die Schwerkraft ab.

Die Magnetkörper 5 der Druckplattenausnehmungen können gemäß einer alternativen Ausführungsform durch Auswurfelemente 24 ausgestoßen werden (Figur 7a). Die Ablösung der Magnete 5 aus den Bondchuckausnehmungen 21 und/oder den Druckplattenausnehmungen 23 kann auch unterhalb der Curietemperatur nur mechanisch durch entsprechende Ausstoßelemente 24 erfolgen. Diese Ausstoßelemente 24 müssen dann entsprechend im Bondchuck 20 (in Fig.4i-4k nicht eingezeichnet) und/oder in der Druckplatte 22 eingebaut sein. Die abgefallenen Magnete 5 werden entsprechend in der Bondkammer aufgefangen und gelagert.

In einer weiteren Ausführungsform werden die Magnetkörper 5 durch einen Elektromagneten 34, bestehend aus einer Spule 33 und einem Magnetkern 32 vom ersten und/oder zweiten Substrat entfernt (Figur 7b). In einer ersten Ausführungsform verwendet man nur einen Elektromagneten 34 von einer Seite. Durch Entfernung eines Magnetkörpers 5 durch den Elektromagneten 32 und anschließende Entfernung des Elektromagneten 34 verliert der zweite Magnetkörper automatische seine Haftung und fällt ab. In einer besonderen Ausführungsform kann ein Elektromagnet 34 an der Ober- und ein weiterer Elektromagnet 34 an der Unterseite des Substratstapels verwendet werden. Die Entfernung der Magnetkörper 5 vom Elektromagneten 34 erfolgt durch das Ausschalten des elektromagnetischen Feldes durch Stoppen der Stromzufuhr durch die Spule 33. Bei der Verwendung zweier Elektromagnete 34 kann man die Ober- bzw. untere Polung entsprechend wählen, sodass sich entweder +/+, -/-, +/- oder -/+ Kombinationsmöglichkeiten ergeben. Die Magnetkörper 5 drehen sich entsprechend solange, bis ihre Pole entsprechend den angelegten Polen der Elektromagnete 34ausgerichtet sind.

In einer weiteren Ausführungsform wird ein U-förmiger Magnetkern verwendet, dessen Pole jeweils auf die Ober- bzw. Unterseite des Substratstapels zeigen (Figur 7c). Erfindungsgemäß wird hier nur eine Spule 33 verwendet. Durch die U-Form des Elektromagneten 34 gemäß Figur 7c erzeugt man mit Hilfe einer einzigen Spule zwei unterschiedliche Pole. Die Möglichkeiten der Polung sind dementsprechend entweder +/- oder -/+. Die Magnetkörper 5 drehen sich entsprechend solange, bis ihre Pole entsprechend den angelegten Polen der Elektromagnete 34 ausgerichtet sind.

Für einen Fachmann auf dem Gebiet ist klar, dass die genannten erfindungsgemäßen Ausführungsformen der Magnetkörperentfernung 5 so gestaltet sind, dass sie in x- und/oder y- und/oder z-Richtung bewegbar sind, sodass sie auf die Magnetkörper 5 zufahren können um sich nach deren erfolgreicher Entfernung wieder vom Substratstapel zu entfernen.

In einer besonderen Ausführungsform werden die Magnetkörper 5 anschließend erneut magnetisiert und wiederverwendet, sodass ein geschlossener Kreislauf entsteht.

Die Bondkräfte, die beim Bondvorgang auftreten, sind größer als 100N, mit Vorzug größer als 1000N, mit größerem Vorzug größer als 10000N, mit noch größerem Vorzug größer als 100000N. Die Bondtemperaturen sind größer als 50°C, mit Vorzug größer als 100°C, mit größerem Vorzug größer als 200°C, mit noch größerem Vorzug größer als 400°C, mit größtem Vorzug größer als 600°C, mit allergrößtem Vorzug größer als 800°C.

Das vorgestellte erfindungsgemäße Verfahren beschränkt sich nicht nur auf den Substrattransport zwischen einem Ausrichtungs- und einem Bondingmodul. Das Verfahren kann grundsätzlich immer verwendet werden, wenn es darum geht, eine Fixierung mehrerer Substrate in einem Substratstapel 14 durchzuführen, um den Substratstapel 14 über eine Strecke zu transportieren. Wenn die erfindungsgemäßen Magnetkörper 5, 5', 5" stark genug sind, wäre sogar ein Transport des Substratstapels 14 über weite Strecken denkbar.

Das erfindungsgemäße Verfahren eignet sich vor allem für das Ausrichten und Bonden in dem Cluster 17, insbesondere einem Hochvakuumcluster.

Bei beiden in Figuren 5a und 5b gezeigten Ausführungsformen besteht der Cluster 17, 17' aus einem Clusterschleusentor 27, einer Zentralkammer 19 und den entsprechenden Modulen 3,16,18. An dem Clusterschleusentor 27 ist ein Eingangs-FOUP (front opening unified pod - Horde [Halterung für mehrere Substrate]) 30 und ein Ausgangs-FOUP 31 zum Be- und Entladen von Substraten 4, 13 angeschlossen.

Die Aufnahme eines Substrats 4, 13 erfolgt mittels eines Robotersystems 15, welches ein Substrat 4, 13 über das Clusterschleusentor 27 in die Zentralkammer 19 holt. Die Zentralkammer ist evakuierbar, mit Vorzug kann sogar ein Ultrahochvakuum eingestellt werden.

Der Druck in der Zentralkammer 19 kann auf unter 10-3 mbar, mit Vorzug auf unter 10-4,mbar, mit größerem Vorzug auf unter 10-5 mbar, mit noch größerem Vorzug auf unter 10-6 mbar, mit größtem Vorzug auf unter 10-7 mbar, mit allergrößtem Vorzug auf unter 10-9 mbar evakuiert werden.

Jedes einzelne der Module 3, 16, 18 kann evakuiert werden und ist von der Zentralkammer durch die Modulschleusentor 26 hermetisch trennbar. Der Druck in jedem Modul kann auf unter 10-3 mbar, mit Vorzug auf unter 10-4,mbar, mit größerem Vorzug auf unter 10-5 mbar, mit noch größerem Vorzug auf unter 10-6 mbar, mit größtem Vorzug auf unter 10-7 mbar, mit allergrößtem Vorzug auf unter 10-9 mbar evakuiert werden.

Bei der ersten Ausführungsform (Fig. 5a) ist jedes der Module 3,16,18 über ein Modulschleusentor 26 mit der Zentralkammer 19 verbunden. Die Module 3, 16, 18 sind sternförmig um die Zentralkammer 19 angeordnet.

In einer zweiten Ausführungsform (Figur 5b) des Clusters 17' sind die unterschiedlichen Module 3, 16, 18 parallel zueinander entlang eines Transportsystems 28 angeordnet, auf dem sich ein oder mehrere Robotersysteme 15 bewegen können. Denkbar wäre auch nur ein Robotersystem 15, auf dem sich mehrere Greifarme befinden. Hier ist jedes der Module 3,16,18 über ein Modulschleusentor 29 mit der Zentralkammer 19 verbunden.

Nachfolgend wird eine besondere Ausführungsform des Bondprozesses beschrieben, welche einerseits die erfindungsgemäße Magnetklemmung und andererseits den Cluster 17 verwendet.

Ein erstes Substrat 4 wird, mit Vorzug aus dem Eingangs-FOUP 30 über das Clusterschleusentor 27, in den Cluster 17 gebracht oder befindet sich bereits innerhalb des Clusters 17. Der Cluster 17 wird mit Vorzug unmittelbar nach dem Schließen des Clusterschleusentors 27 evakuiert. Danach bewegt das Robotertransportsystem 15 das Substrat 4 in ein Vorbehandlungsmodul 18. Das Vorbehandlungsmodul 18 wird evakuiert, bevor das Modulschleusentor 26 geöffnet wird. Das erste Substrat 4 wird anschließend in das Vorbehandlungsmodul 18 eingebracht und entsprechend vorbehandelt. Bei dem Vorbehandlungsmodul kann es sich beispielsweise um ein Heizmodul, ein Plasmamodul, eine Ionenanlage zum Beschießen der Substratoberfläche mit Ionen, eine Sputteranlage, ein Modul zur UV-Bestrahlung, ein Modul zur Metallabscheidung (PVD, CVD, PECVD, ALD) um eine Anlage zur gezielten Oxidation der Substratoberfläche etc. handeln.

Eine entsprechend analoge Vorbehandlung erhält das zweite Substrat 13 im gleichen und/oder einem entsprechenden, separaten Modul 18.

Das erste Substrat 4 wird von einem Vorbehandlungsmodul in ein Prealignmentmodul gebracht, in dem eine Grobausrichtung des ersten Substrats 4 erfolgt.

Das zweite Substrat 13 wird vom Roboterarm des Robotertransportsystems aus dem Vorbehandlungsmodul geholt, gedreht und im Prealignmentmodul und ebenfalls grob vorpositioniert. Die Ausrichtungsgenauigkeiten der groben Vorausrichtung (Justierung) des ersten Substrats 4 und/oder des zweiten Substrats 13 sind besser als 1 mm, mit Vorzug besser als 500 µm, mit größerem Vorzug besser als 250 µm, mit noch größerem Vorzug besser als 100 µm, mit größtem Vorzug besser als 50 µm, mit allergrößtem Vorzug besser als 20 µm.

Das erste Substrat 4 wird in das Ausrichtungsmodul 3 gebracht und dort vorfixiert, beispielsweise durch einen elektrostatischen Substrathalter, durch mechanische Klemmen, durch Vakuumsubstrathalter oder durch Adhäsion. Das zweite Substrat 13 wird ebenfalls in die Ausrichtungsmodul 3 gebracht und relativ zum ersten Substrat 13 in X-Y Richtung (also parallel zur jeweiligen Kontaktfläche 4o, 13o) justiert. Des Weiteren wird ein Keilfehlerausgleich vorgenommen sowie eine relativen Annäherung beider Substrate 4, 13 aus einem Abstand von mehreren Millimetern bis Zentimetern auf einen Abstand von ca. 20µm-2000µm.

Nach der erfolgreichen Kontaktierung erfolgt die erfindungsgemäße Klemmung des aus den beiden kontaktierten Substraten 4, 13 bestehenden Substratstapels 14 mittels der Magnetklemmen.

Anschließend erfolgt der Transfer in eine Bondkammer 16 innerhalb des Clusters 17. Der Substratstapel 14 wird durch das Robotertransportsystem 15 auf Pins im Bonder abgelegt. Die pins senken sich und legen den Substratstapel auf dem Bondchuck ab. Der Bondchuck 20 und/oder die Druckplatte 22 sind gemäß der erfindungsgemäßen Ausführungsformen so gefertigt, dass er die Magnetkörper 5, 5', 5" aufnehmen kann.

Danach kommt es zur Kontaktierung der Oberfläche der Druckplatte 22 mit dem Substratstapel 14. Vom Zeitpunkt des mechanischen Kontakts zwischen Bondchuck 20, Substratstapel 14 und Druckplatte 22 können die Magnete 5, 5', 5" entfernt werden. Entweder sie fallen auf Grund des Verlusts des Ferromagnetismus bei einer Temperatur oberhalb der Curietemperatur von alleine ab oder sie werden vor und/oder nach der Temperaturerhöhung mechanisch entfernt.

Erfindungsgemäß denkbar ist nun eine Wärmebehandlung, das Einbringen von UV Energie über eine für UV Licht transparente Druckplatte 22 in die Bondkammer oder das Anlegen einer elektrischen Spannung zwischen Ober- und Unterseite des Substratstapels wie man es für das anodische Bonding benötigt.

Vor dem Entladen des Substratstapels 14 wird mit Vorzug die Bondkammer, und damit der Substratstapel, auf eine zwischen der Bondtemperatur und der Raumtemperatur liegende Entladetemperatur gebracht. Danach wird die Bondkammer geöffnet und die pins heben den Substratstapel an, sodass er vom Robotertransportsystem entnommen werden kann. Zu diesem Zeitpunkt befinden sich die Magnete 5,5',5" bereits in einem Sammelbehälter innerhalb oder in der Nähe der Bondkammer.

Danach wird der Substratstapel mit Vorzug in ein Kühlmodul transportiert. Innerhalb des Kühlmoduls erfolgt eine Abkühlung auf Raumtemperatur.

Der fertige Substratstapel wird über das Clusterschleusentor 27 aus dem Hochvakuumcluster in der Ausgangs FOUP 31 abgelegt.

In der einfachsten dargestellten Ausführungsform wirkt die Zentralkammer 19 als Schleuse, welche über das Clusterschleusentor 27 und/oder die Modulschleusentore 26 die Module von der Zentralkammer 19 und/oder der Umgebung trennt. Erfindungsgemäß denkbar wäre allerdings auch die Schaffung eigener Schleusen vor jedem Modul 3,16,18 und/oder den Eingangs- bzw. Ausgangs FOUPS, um den Durchsatz der verwendeten Wafer zu erhöhen und einen kontinuierlichen Betrieb bzw. einen kontinuierlichen Betrieb mit Speicherkapazität von weiteren FOUPs zu gewährleisten.

Die Anzahl der Schleusen zwischen der Zentralkammer 19 und/oder den Modulen 3, 16, 18 bzw. zwischen der Zentralkammer 19 und den Eingangs- bzw. Ausgangs FOUPS kann beliebig hoch sein. Von besonderem Vorteil ist die Verwendung von mindestens einer, mit Vorzug mindestens von zwei, mit größerem Vorzug von mindestens drei, mit noch größerem Vorzug von mindestens vier, mit größtem Vorzug von mindestens fünf, mit allergrößtem Vorzug von mindestens sechs Schleusen.

### Bezugszeichenliste e

- 1: Erster Substrathalter
- 1o: Aufnahmeoberfläche
- 2: Ausnehmungen
- 2o: Auflageabschnitt
- 3: Ausrichtungsmodul
- 4: Erstes Substrat
- 4h: Halteseite
- 4o: erste Kontaktfläche
- 5, 5', 5": Magnetkörper
- 5p: Magnetelementpaare
- 5'o: Basisfläche des Zylindermagneten
- 6: Semi- bzw. Vollautomatisches Befüllungssystem
- 7: Schlauch
- 8: Halterung
- 9: Ventil
- 11: Ausrichtungsmarkierungen
- 12: Optiken
- 13: Zweites Substrat
- 13h: Halteseite
- 13o: zweite Kontaktfläche
- 14: Erfindungsgemäßer Substratstapel
- 15: Robotertransportsystem
- 16: Bondmodul
- 17: Hochvakuumcluster
- 18: Modul
- 19: Zentralkammer
- 20: Bondchuck
- 20o: Aufnahmefläche
- 21: Bondchuckausnehmungen
- 21o: Oberfläche
- 22: Druckplatte
- 23: Druckplattenausnehmungen
- 23o: Oberfläche
- 24: Auswurfelemente
- 25: Trägerplatte
- 25o: Stützfläche
- 26: Modulschleusentor
- 27: Clusterschleusentor
- 28: Transportsystem
- 29: Modulschleusentor
- 30: Eingangs FOUP
- 31: Ausgangs FOUP
- 32: Magnetkern
- 33: Spule
- 34: Magnet
- dmax: Substratstapeldicke
- Fmag: Haltekraft, Magnetkraft
- K1: Erstes magnetisches Material mit einer geringen Magnetisierung.
- K2: Zweites magnetisches Material mit einer starken Magnetisierung.

## Patentansprüche

1. Aufnahmeeinrichtung (1, 20) zur Handhabung eines mit einem zweiten Substrat (13) zu bondenden ersten Substrats (4) mit:
- einer Aufnahmefläche (1o, 20o) zur Aufnahme des ersten Substrats (4) und
- mindestens zwei gegenüber der Aufnahmefläche (1o, 20o) zurückgesetzte Ausnehmungen (2, 21) zur Aufnahme von magnetisch wirkenden Fixiermitteln (5, 5', 5") zur Festlegung des ersten Substrats (4) gegenüber dem zweiten, mit dem ersten Substrat (4) ausgerichteten Substrat (13),
- wobei weitere Magnetkörper (5, 5', 5") auf eine Halteseite (13h) des zweiten Substrats (13) aufbringbar sind, **dadurch gekennzeichnet, dass** ein Substratstapel (14) aus dem ersten Substrat (4) und dem zweiten Substrat (13) unter Weglassung der Aufnahmeeinrichtung (1, 20) festlegbar ist.

2. Aufnahmeeinrichtung gemäß Patentanspruch 1, bei der die Ausnehmungen (2, 21) als am Umfang angeordnete Absätze mit einem Auflageabschnitt (2o, 21o) zur Auflage der Fixiermittel (5, 5', 5") und einem zum Zentrum der Auflagefläche (1o, 20o) gerichteten Anlageabschnitt (2o, 21o) zur Anlage der Fixiermittel (5, 5', 5") ausgebildet sind.

3. Aufnahmeeinrichtung nach einem der vorhergehenden Patentansprüche, bei der der Auflageabschnitt (2o, 21o) gegenüber der Aufnahmefläche (1o, 20o) um einen Winkel a kleiner 60°, insbesondere a kleiner 45°, vorzugsweise a kleiner 30°, noch bevorzugter a kleiner 15°, geneigt ist.

4. Aufnahmeeinrichtung nach einem der vorhergehenden Ansprüche, bei der die Ausnehmungen (2, 21) am Umfang der Aufnahmefläche (1o, 20o) gleichmäßig verteilt angeordnet sind.

5. Vorrichtung zur Handhabung eines aus einem auf einer Aufnahmeeinrichtung gemäß Anspruch 1 aufgenommenem ersten Substrat (4) und
einem gegenüber dem ersten Substrat (4) ausgerichteten zweiten Substrat (13) bestehenden Substratstapels (14) mit magnetisch wirkenden Fixiermitteln (5, 5', 5") zur Festlegung des ersten Substrats (4) relativ zu dem zweiten Substrat (13) in einer ausgerichteten Festlegungsposition, wobei die Vorrichtung eine Platzierungseinrichtung (6) zur Platzierung der Fixiermittel (5, 5', 5") auf voneinander abgewandten Seiten des Substratstapels (14) aufweist, **dadurch gekennzeichnet, dass** der Substratstapel (14) unter Weglassung der Aufnahmeeinrichtung festlegbar ist.

6. Vorrichtung nach Anspruch 5, wobei die Fixiermittel (5, 5', 5") mindestens zwei Magnetelementpaare (5p) aufweisen.

7. Vorrichtung nach Anspruch 6, wobei jedes Magnetelementpaar (5p) aus einem ersten magnetisch wirksamen Magnetkörper (5, 5', 5") und einem von dem ersten Magnetkörper (5, 5', 5") magnetisch angezogenen zweiten, insbesondere magnetisch wirksamen, Magnetkörper (5, 5', 5") gebildet ist.

8. Vorrichtung nach Anspruch 7, wobei die ersten und/oder die zweiten Magnetkörper (5, 5', 5") kugelförmig ausgebildet sind.

9. Vorrichtung nach Anspruch 7 oder 8, wobei die ersten und/oder die zweiten Magnetkörper (5, 5', 5") in der Festlegungsposition zumindest überwiegend, insbesondere ausschließlich, durch die vom Magnetelementpaar (5p) erzeugte Magnetkraft an dem Substratstapel (14) fixiert sind.

10. Vorrichtung nach einem der Ansprüche 5 bis 9, wobei die Vorrichtung eine Aufnahmeeinrichtung nach einem der Ansprüche 1 bis 4 aufweist.

11. Vorrichtung nach einem der Ansprüche 5 bis 10, wobei die Vorrichtung eine Ausrichtungseinrichtung zur Ausrichtung des ersten Substrats (4) relativ zu dem zweiten Substrat (13) sowie eine Kontaktierungseinrichtung zur Kontaktierung der Substrate (4, 13) aufweist.

12. Verfahren zur Handhabung eines aus einem ersten Substrat (4) und einem gegenüber dem ersten Substrat (4) ausgerichteten zweiten Substrat (13) bestehenden, zu bondenden Substratstapels (14), wobei das erste Substrat (4) zur Handhabung des Substratstapels (14) relativ zu dem zweiten Substrat (13) durch magnetisch wirkende Fixiermittel (5, 5', 5") in einer ausgerichteten Festlegungsposition festgelegt wird, wobei die Fixiermittel (5, 5', 5") auf voneinander abgewandten Halteseiten (4h, 13h) des Substratstapels (14) platziert werden, **dadurch gekennzeichnet, dass** der Substratstapel (14) unter Weglassung einer Aufnahmeeinrichtung festgelegt wird.

13. Substratstapel (14) bestehend aus einem mit einem zweiten Substrat zu bondenden ersten Substrat, fixiert durch magnetische Fixiermittel (5, 5', 5"), die auf voneinander abgewandten Halteseiten (4h, 13h) des Substratstapels (14) platziert sind, **dadurch gekennzeichnet, dass** der Substratstapel (14) unter Weglassung einer Aufnahmeeinrichtung festgelegt ist.

14. Substratstapel nach Anspruch 13, **dadurch gekennzeichnet, dass** die Fixiermittel (5, 5', 5") kugelförmig sind.

## Claims

1. Retaining system (1, 20) for handling a first substrate (4) that is to be bonded with a second substrate (13) with:
- A retaining surface (1o, 20o) for retaining a first substrate (4), and
- At least two recesses (2, 21), recessed relative to the retaining surface (1o, 20o), for retaining magnetically acting attachment means (5, 5', 5") for securing the first substrate (4) relative to a second substrate (13) that is aligned with the first substrate (4),
- wherein further magnetic bodies (5, 5', 5") can be brought onto a holding side (13h), **characterized in that** a substrate stack (14) formed by the first substrate (4) and the second substrate (13) can be fixed under omission of the retaining system (1, 20).

2. Retaining system according to Claim 1, in which the recesses (2, 21) are designed as shelves, arranged on the periphery, with a seating section (2o, 21o) for seating of the attachment means (5, 5', 5") and an installation section (2o, 21o), directed toward the center of the seating surface (1o, 20o), for installation of the attachment means (5, 5', 5").

3. Retaining system according to one of the preceding claims, in which the seating section (2o, 21o) is inclined relative to the seating surface (1o, 20o) by an angle a less than 60°, in particular a less than 45°, preferably a less than 30°, and even more preferably a less than 15°.

4. Retaining system according to one of the preceding claims, in which the recesses (2, 21) are arranged uniformly distributed on the periphery of the retaining surface (1o, 20o).

5. Device for handling a substrate stack (14), retained by a retaining system (1, 20) according to claim 1 and consisting of a first substrate (4) and a second substrate (13) aligned relative to the first substrate (4), with magnetically acting attachment means (5, 5', 5") for securing the first substrate (4) relative to the second substrate (13) in an aligned immobilized position, wherein the device comprises a placing system (6) for placing the attachment means (5, 5', 5") on sides of the substrate stack (14) that are facing away from one another **characterized in that** the substrate stack (14) can be fixed under omission of the retaining system (1, 20).

6. Device according to Claim 5, whereby the attachment means (5, 5', 5") have at least two pairs of magnetic elements (5p).

7. Device according to Claim 6, whereby each pair of magnetic elements (5p) is formed from a first magnetically active magnetic body (5, 5', 5") and a second, in particular magnetically active, magnetic body (5, 5', 5") that is magnetically attracted by the first magnetic body (5, 5', 5").

8. Device according to Claim 7, whereby the first and/or the second magnetic body(ies) (5, 5', 5") is/are designed in the shape of a sphere.

9. Device according to Claim 7 or 8, whereby the first and/or the second magnetic body(ies) (5, 5', 5") is/are attached to the substrate stack (14) in the immobilized position at least predominantly, in particular exclusively, by the magnetic force produced by the pair of magnetic elements (5p).

10. Device according to one of Claims 5 to 9, whereby the device has a retaining system according to one of Claims 1 to 4.

11. Device according to one of Claims 5 to 10, whereby the device has an alignment system for aligning the first substrate (4) relative to the second substrate (13) as well as a contacting system for bringing the substrates (4, 13) into contact.

12. Method for handling a substrate stack (14) that is to be bonded and that consists of a first substrate (4) and a second substrate (13) that is aligned relative to the first substrate (4), whereby the first substrate (4) is secured in an aligned immobilized position by magnetically acting attachment means (5, 5', 5") for handling the substrate stack (14) relative to the second substrate (13), whereby the attachment means (5, 5', 5") are placed on holding sides (4h, 13h) of the substrate stack (14) that face away from one another, **characterized in that** the substrate stack (14) is fixed under omission of a retaining system (1,20).

13. Substrate stack (14) consisting of a first substrate to be bonded with a second substrate, fixed by magnetic attachment means (5, 5', 5") arranged on holding sides (4h, 13h) facing away from each other, **characterized in that** substrate stack (14) is fixed under omission of a retaining system (1, 20).

14. Substrate stack according to claim 13, **characterized in that** the attachment means (5, 5', 5") is/are designed in the shape of a sphere.

## Revendications

1. Système de logement (1, 20) pour la manipulation d'un premier substrat (4) qui doit être relié avec un deuxième substrat (13), avec :
- une surface de logement (10, 200) destinée à recevoir le premier substrat (4) et
- au moins deux évidements (2, 21) en retrait par rapport à la surface de logement (10, 200), destinés à recevoir des moyens de fixation (5, 5', 5") à effet magnétique, pour l'immobilisation du premier substrat (4) par rapport au deuxième substrat (13) aligné sur le premier substrat (4),
- des corps magnétiques (5, 5', 5") supplémentaires pouvant être appliqués sur un côté de maintien (13h) du deuxième substrat (13), **caractérisé en ce qu'**une pile de substrats (14) composée du premier substrat (4) et du deuxième substrat (13) peut être immobilisée en omettant le système de logement (1, 20).

2. Système de logement selon la revendication 1, sur lequel les évidements (2, 21) sont conçus en tant que gradins placés sur la périphérie, avec un segment de repos (20, 210) pour faire reposer les moyens de fixation (5, 5', 5") et un segment d'appui (20, 210) dirigé vers le centre de la surface de repos (10, 200), pour appuyer les moyens de fixation (5, 5', 5").

3. Système de logement selon l'une quelconque des revendications précédentes, sur lequel le segment de repos (20, 210) est incliné par rapport à la surface de logement (10, 200) de la valeur d'un angle α inférieur à 60°, notamment α inférieur à 45 °, de préférence α inférieur à 30°, de manière encore plus préférée α inférieur à 15°.

4. Système de logement selon l'une quelconque des revendications précédentes, sur lequel les évidements (2, 21) sont placés en étant distribués régulièrement sur la périphérie de la surface de logement (10, 200).

5. Dispositif pour la manipulation d'une pile de substrats (14) constituée d'un premier substrat (4) logé dans un système de logement selon la revendication 1 et d'un deuxième substrat (14) aligné par rapport au premier substrat (4), avec des moyens de fixation (5, 5', 5") à effet magnétique pour immobiliser le premier substrat (4) par rapport au deuxième substrat (13) dans une position d'immobilisation alignée, le dispositif comportant un dispositif de placement (6) pour le placement des moyens de fixation (5, 5', 5") sur des côtés mutuellement opposés de la pile de substrats (14), **caractérisé en ce que** la pile de substrats (14) peut être immobilisée en omettant le système de logement.

6. Dispositif selon la revendication 5, les moyens de fixation (5, 5', 5") comportant au moins deux paires (5p) d'éléments magnétiques.

7. Dispositif selon la revendication 6, chaque paire (5p) d'éléments magnétiques étant formée d'un premier corps magnétique (5, 5', 5") à effet magnétique et d'un deuxième corps magnétique (5, 5', 5"), notamment à effet magnétique, magnétiquement attiré par le premier corps magnétique (5, 5', 5").

8. Dispositif selon la revendication 7, les premiers et/ou les deuxièmes corps magnétiques (5, 5', 5") étant conçus de forme sphérique.

9. Dispositif selon la revendication 7 ou la revendication 8, dans la position d'immobilisation, les premiers et/ou les deuxièmes corps magnétiques (5, 5', 5") étant au moins en majeure partie, notamment exclusivement fixés sur la pile de substrats (14) par la force magnétique générée par la paire (5p) d'éléments magnétiques.

10. Dispositif selon l'une quelconque des revendications 5 à 9, le dispositif comportant un système de logement selon l'une quelconque des revendications 1 à 4.

11. Dispositif selon l'une quelconque des revendications 5 à 10, le dispositif comportant un système d'alignement, pour aligner le premier substrat (4) par rapport au deuxième substrat (13), ainsi qu'un système de mise en contact pour mettre en contact les substrats (4, 13).

12. Procédé destiné à la manipulation d'une pile de substrats (14) devant être reliée, constituée d'un premier substrat (4) et d'un deuxième substrat (13) aligné par rapport au premier substrat (4), lors duquel, pour la manipulation de la pile de substrats (14), on immobilise le premier substrat (4) par rapport au deuxième substrat (13) dans une position d'immobilisation alignée, par des moyens de fixation (5, 5', 5") à effet magnétique, lors duquel on place les moyens de fixation (5, 5', 5") sur des côtés de maintien (4h, 13h) mutuellement opposés de la pile de substrats (14), **caractérisé en ce qu'**on immobilise la pile de substrats (14) en omettant un système de logement.

13. Pile de substrats (14) constituée d'un premier substrat qui doit être relié avec un deuxième substrat, fixée par des moyens de fixation (5, 5', 5") magnétiques, qui sont placés sur des côtés de maintien (4h, 13h) mutuellement opposés de la pile de substrat (14), **caractérisée en ce qu'**on immobilise la pile de substrats (14) en omettant un système de logement.

14. Pile de substrats selon la revendication 13, **caractérisée en ce que** les moyens de fixation (5, 5', 5") sont de forme sphérique.
